# EUROPEAN PATENT SPECIFICATION

(11) **EP 4 703 844 B1**
(45) Date of publication and mention of the grant of the patent: **23.09.2026**
(21) Application number: 25198220.3
(22) Date of filing: 26.08.2025
(51) Int. Cl.: G06F 1/16

(54) **DISPLAY DEVICE AND ELECTRONIC DEVICE INCLUDING THE SAME**
ANZEIGEVORRICHTUNG UND ELEKTRONISCHE VORRICHTUNG DAMIT
DISPOSITIF D'AFFICHAGE ET DISPOSITIF ÉLECTRONIQUE LE COMPRENANT

(30) Priority: 02.09.2024 KR 20240118730
(43) Date of publication of application: 04.03.2026
(73) Proprietor: Samsung Display Co., Ltd., Yongin-si, Gyeonggi-do 17113 (KR)
(72) Inventor: LEE, Sang Wol, 17113 Yongin-si (KR)
(74) Representative: Taor, Simon Edward William

(56) References cited:
- US-A1- 2023 021 638
- US-A1- 2023 229 189
- US-A1- 2023 244 274

## Description

### BACKGROUND

### 1. Technical Field

Implementations of the disclosure generally relate to a display device.

2. Description of the Related Art A display device is a device that displays an image, and includes a display panel that includes display elements such as organic light emitting diodes (OLED) and quantum dot electroluminescence diodes (QD-EL), etc.

Meanwhile, mobile electronic devices include a display device to provide images to a user. Recently, foldable display devices that can be folded and unfolded are being developed to provide a larger screen when in use than when carrying around.

Examples of such foldable display devices are described in US 2023/244274 A1, US 2023/021638 A1, or US 2023/229189 A1.

### SUMMARY

Embodiments provide a display device.

Embodiments provide an electronic device including the display device.

A display device according to an embodiment may include a display module including a folding portion and at least one of a non-folding portion disposed adjacent to the folding portion, a first hinge assembly disposed under the display module and including a first lever, a first link, and a first roller, and a first wing plate disposed between the display module and the first hinge assembly, wherein the first lever overlaps the folding portion and rotates around a first lever rotation axis, the first link rotates around a first link rotation axis, and the first roller is fixedly attached to the first link and moves along a first slot, and the first wing plate overlaps the folding portion, rotates along the first lever, and contacts the first roller.

In an embodiment, the folding portion may include a curved portion and a first bend portion disposed between the curved portion and the non-folding portion, the curved portion may be in-folded in a first folding state following an unfolding state, and the first bend portion may be out-folded in a second folding state following the first folding state.

In an embodiment, the first wing plate may be divided into a first portion and a second portion, the first portion may be disposed adjacent to the non-folding portion, the second portion may be connected to the first portion, have a thickness smaller than a thickness of the first portion, and be disposed adjacent to the first lever rotation axis. The first roller may contact the first portion in the first folding state.

In an embodiment, the first roller may support the first portion in the first folding state, and in case that the first portion is supported by the first roller, the display module overlapping the first portion may be not folded.

In an embodiment, the first roller may not support the first portion in the second folding state, and in case that the first portion is not supported by the first roller, the display module overlapping a boundary of the first portion may be folded.

In an embodiment, the first portion may include a lower surface contacting the first roller and an upper surface facing the lower surface and parallel to the lower surface.

In an embodiment, a position of the first link rotation axis may be different from a position of the first lever rotation axis, and the first link rotation axis may be positioned under the first lever rotation axis.

In an embodiment, the display device may further include at least one gear connecting the first lever and the first link.

In an embodiment, the gear may include a first gear and a second gear, the first gear may be connected between the second gear and the first link, and the second gear may be connected between the first gear and the first lever.

In an embodiment, the gear may include a first gear and a second gear, the first gear may be connected to the second gear, and the second gear may be connected between the first lever and the first link.

In an embodiment, a groove corresponding to the first roller may be formed at an end of the first link, and the first roller may be fixedly attached to the first link in the groove through a first roller pin.

In an embodiment, the first slot may be formed in the first lever.

In an embodiment, the first hinge assembly may further include a second lever that rotates around a second lever rotation axis, a second link that rotates around a second link rotation axis, and a second roller fixedly attached to the second link to move along a second slot.

In an embodiment, the first hinge assembly may further include a third link that rotates around the first link rotation axis and opposing the first link with the first lever and a third roller fixedly attached to the third link and opposing the first roller with the first lever.

In an embodiment, the display device may further include a second wing plate disposed between the display module and the first hinge assembly, wherein the second wing overlaps the folding portion, rotates around the second lever, and contacts the second roller.

In an embodiment, the display device may further include a second hinge assembly disposed under the display module, overlapping the folding portion, and having a same shape as the first hinge assembly.

In an embodiment, the display module may include a first folding portion and a second folding portion spaced apart from the first folding portion, and the first and second hinge assemblies may overlap the first folding portion.

In an embodiment, the display device may further include a third hinge assembly disposed under the display module and overlapping the second folding portion.

In an embodiment, the display module may include a display panel and a support member disposed under the display panel and having a hole overlapping the folding portion.

An electronic device according to an embodiment may include a display device including a display module and a first hinge assembly, a power supply that supplies power to the display device; and a first wing plate disposed between the display module and the first hinge assembly. The display module may include a folding portion and at least one of a non-folding portion disposed adjacent to the folding portion, the first hinge assembly may be disposed under the display module and include a first lever, a first link, and a first roller, wherein the first lever may overlap the folding portion and rotates around a first lever rotation axis, the first link rotates around a first link rotation axis, and the first roller is fixedly attached to the first link to move along a first slot, and the first wing plate overlaps the folding portion, rotates along the first lever, and contacts the first roller.

Therefore, a display device according to embodiments of the disclosure may include a display module, a hinge assembly, and a wing plate. The hinge assembly may include a lever, a link, and a roller. The lever may rotate around a lever rotation axis, and the link may rotate around a link rotation axis. The roller may be fixedly attached to the link and guided by a slot. The wing plate may be located between the display module and the hinge assembly.

The position of the lever rotation axis may be different from the position of the link rotation axis. Accordingly, the rotation trajectory of the lever may be different from the rotation trajectory of the link. The roller may be guided by the slot and may move linearly. In other embodiments, the display device may induce the rotation trajectory of the lever and the rotation trajectory of the link differently by using two rotation axes positioned at different locations. The linear movement of the roller may be induced by using the difference between the above-described rotation trajectories.

The wing plate may include a first portion and a second portion having different thicknesses, and the relatively thick first portion may be supported by the roller.

Accordingly, in the first folding state, a curved portion of the display device may be in-folded, and bend portions may not be bent or folded. Accordingly, no wrinkles can occur in the folding portion in case that a user uses the display device.

In the second folding state and in the folding state following the first folding state, the curved portion may be in-folded and the bend portions may be out-folded. Accordingly, an increase in the thickness of the display device may be compensated in case that the user carries the display device.

According to an aspect, there is provided a display device as set out in claim 1. Additional features are set out in claims 2 to 14. According to an aspect, there is provided an electronic device as set out in claim 15.

### BRIEF DESCRIPTION OF THE DRAWINGS

The accompanying drawings, which are included to provide a further understanding of the disclosure and are incorporated in and constitute a part of this specification, illustrate embodiments of the disclosure together with the description.
FIGS. 1 and 2 are schematic perspective views illustrating a display device according to an embodiment of the disclosure.
FIG. 3 is an exploded schematic perspective view illustrating the display device of FIG. 1.
FIG. 4 is a schematic perspective view illustrating the display device of FIG. 3.
FIG. 5 is a schematic cross-sectional view illustrating a display module included in the display device of FIG. 3.
FIG. 6 is a schematic cross-sectional view illustrating a display panel included in the display module of FIG. 5.
FIG. 7 is a schematic plan view illustrating a support member included in the display module of FIG. 5.
FIG. 8 is an exploded schematic perspective view illustrating a hinge assembly included in the display device of FIG. 3.
FIGS. 9, 10, and 11 are schematic views illustrating the hinge assembly of FIG. 8.
FIGS. 12, 13, and 14 are schematic views illustrating the display device of FIG. 3.
FIG. 15 is a schematic view illustrating the display device of FIG. 3.
FIG. 16 is a schematic view illustrating a display device according to another embodiment of the disclosure.
FIG. 17 is a schematic cross-sectional view illustrating a display device according to still another embodiment of the disclosure.
FIG. 18 is an exploded schematic perspective view illustrating the display device of FIG. 17.
FIG. 19 is a schematic perspective view illustrating the display device of FIG. 17.
FIG. 20 is a schematic cross-sectional view illustrating a display device according to still another embodiment of the disclosure.
FIG. 21 is an exploded schematic perspective view illustrating the display device of FIG. 20.
FIG. 22 is a schematic perspective view illustrating the display device of FIG. 20.
FIG. 23 is a schematic block diagram illustrating an electronic device according to an embodiment of the disclosure.
FIG. 24 is a schematic diagram of electronic devices.

### DETAILED DESCRIPTION OF THE EMBODIMENTS

In the following description, for the purposes of explanation, numerous specific details are set forth in order to provide a thorough understanding of various embodiments or implementations of the invention. As used herein "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing features of the invention. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals and/or reference characters denote like elements.

When an element, such as a layer, is referred to as being "on,'' "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the X-axis, the Y-axis, and the Z-axis are not limited to three axes of a rectangular coordinate system, such as the x, y, and z axes, and may be interpreted in a broader sense. For example, the X-axis, the Y-axis, and the Z-axis may be perpendicular to one another, or may represent different directions that are not perpendicular to one another. For the purposes of this disclosure, "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (e.g., microcode) to perform various functions discussed herein and may optionally be driven by firmware and/or software. It is also contemplated that each block, unit, and/or module may be implemented by dedicated hardware, or as a combination of dedicated hardware to perform some functions and a processor (e.g., one or more programmed microprocessors and associated circuitry) to perform other functions. Also, each block, unit, and/or module of some embodiments may be physically separated into two or more interacting and discrete blocks, units, and/or modules without departing from the scope of the inventive concepts. Further, the blocks, units, and/or modules of some embodiments may be physically combined into more complex blocks, units, and/or modules without departing from the scope of the inventive concepts.

Illustrative, non-limiting embodiments will be more clearly understood from the following detailed description in conjunction with the accompanying drawings.

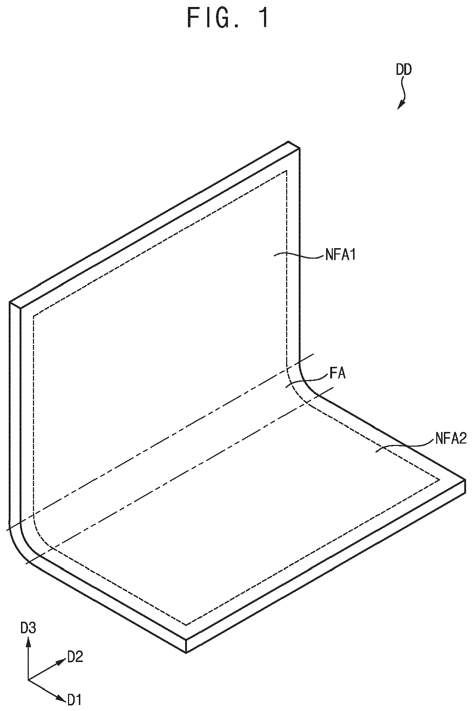

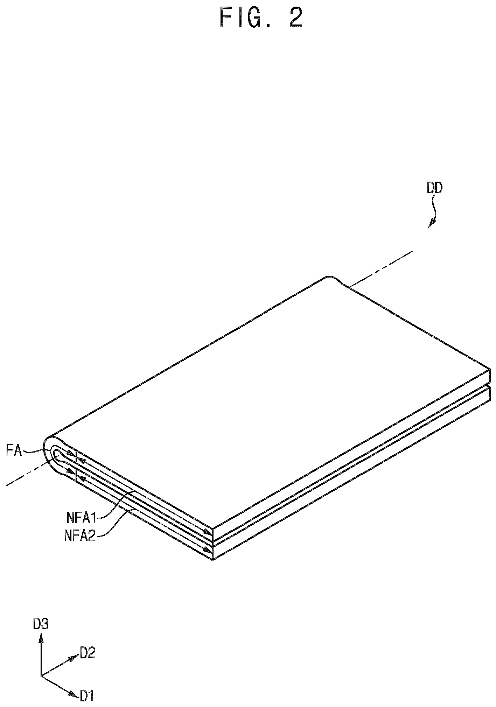

FIGS. 1 and 2 are schematic perspective views illustrating a display device according to an embodiment of the disclosure.

Referring to FIGS. 1 and 2, a display device DD according to an embodiment of the disclosure may include at least one folding portion and at least one non-folding portion. For example, as shown in FIG. 1, the display device DD may include a folding portion FA, a first non-folding portion NFA1, and a second non-folding portion NFA2. The second non-folding portion NFA2 may be disposed adjacent to the first non-folding portion NFA1 in a first direction D1, and the folding portion FA may be positioned between the first and second non-folding portions NFA1 and NFA2.

The folding portion FA, the first non-folding portion NFA1, and the second non-folding portion NFA2 may have a display surface formed in the first direction D1 and a second direction D2 intersecting the first direction D1. The display device DD may display an image in a third direction D3 intersecting the first and second directions D1 and D2 through the display surface.

The folding portion FA may repeatedly perform folding and unfolding. Accordingly, as shown in FIG. 1, in case that the display device DD is implemented as a laptop, a user can use the display device DD by unfolding the folding portion FA at a desired angle (for example, from about 70° to about 120°). While the user uses the display device DD, an image can be displayed on the first non-folding portion NFA1, the folding portion FA, and the second non-folding portion NFA2. As shown in FIG. 2, the user can carry the display device DD by folding the folding portion FA at a desired angle (for example, about 0°).

In the case of a conventional foldable display device, a crease may occur in the folding portion in case that the user is using the foldable display device. Accordingly, the user may feel a sense of incongruity. In case that the user is carrying the foldable display device, the thickness of the foldable display device may increase.

To compensate for these disadvantages, the display device DD of the disclosure can prevent wrinkles from occurring in the folding portion FA during use and can compensate for an increase in the thickness of the display device DD during carrying.

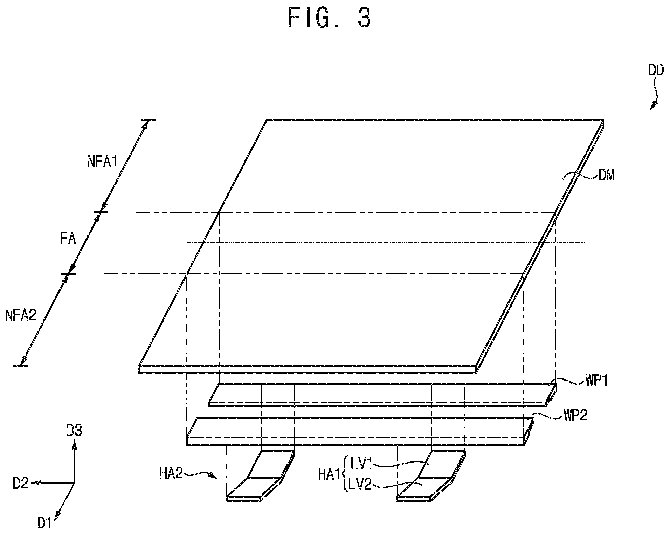

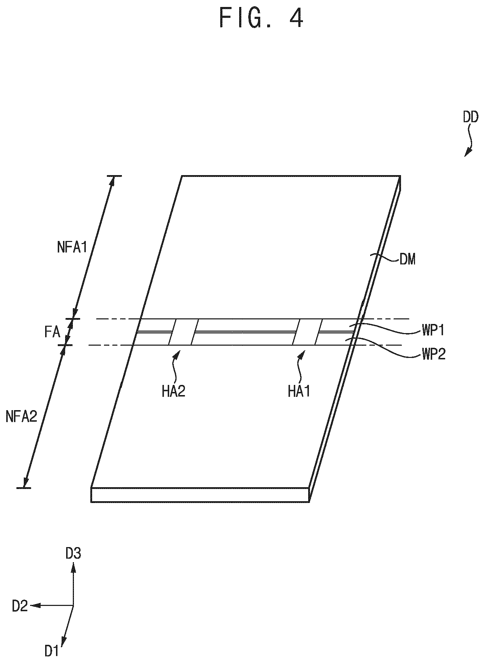

FIG. 3 is an exploded schematic perspective view illustrating the display device of FIG. 1. FIG. 4 is a schematic perspective view illustrating the display device of FIG. 3.

Referring to FIGS. 3 and 4, the display device DD may include a display module DM, a first wing plate WP1, a second wing plate WP2, a first hinge assembly HA1, and a second hinge assembly HA2.

The display module DM may include a display panel and may display an image.

The first wing plate WP1 may be disposed under the display module DM and may overlap the folding portion FA in a third direction D3 (or thickness direction). For example, the first wing plate WP1 may extend in the second direction D2 and may overlap the folding portion FA disposed adjacent to the first non-folding portion NFA1.

The second wing plate WP2 may be disposed under the display module DM and may overlap the folding portion FA in the third direction D3 (or thickness direction). For example, the second wing plate WP2 may extend in the second direction D2, may be disposed adjacent to the first wing plate WP1 in the first direction D1, and may overlap the folding portion FA disposed adjacent to the second non-folding portion NFA2.

The first hinge assembly HA1 may be disposed under the first and second wing plates WP1 and WP2. For example, the first hinge assembly HA1 may include a first lever LV1 and a second lever LV2. The first lever LV1 may correspond to the first wing plate WP1, and the second lever LV2 may correspond to the second wing plate WP2.

The second hinge assembly HA2 may be disposed under the first and second wing plates WP1 and WP2. For example, the second hinge assembly HA2 may have the same shape as the first hinge assembly HA1 and may be disposed adjacent to the first hinge assembly HA1 in the second direction D2.

The first and second hinge assemblies HA1 and HA2 may serve as hinges that guide folding and unfolding. The first and second wing plates WP1 and WP2 may evenly transmit the force generated from the first and second hinge assemblies HA1 and HA2 to the folding portion FA.

As shown in FIGS. 3 and 4, the display device DD may include two hinge assemblies. However, embodiments of the disclosure are not limited thereto. For smooth folding, the display device DD may further include two or more hinge assemblies.

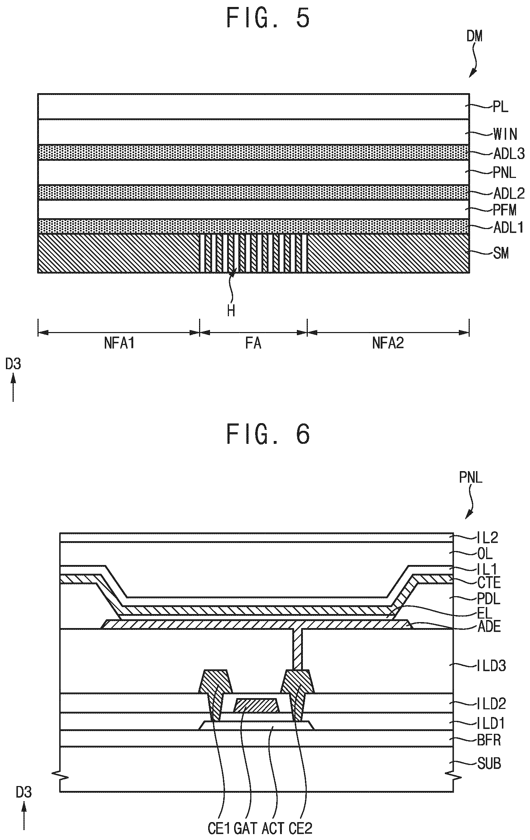

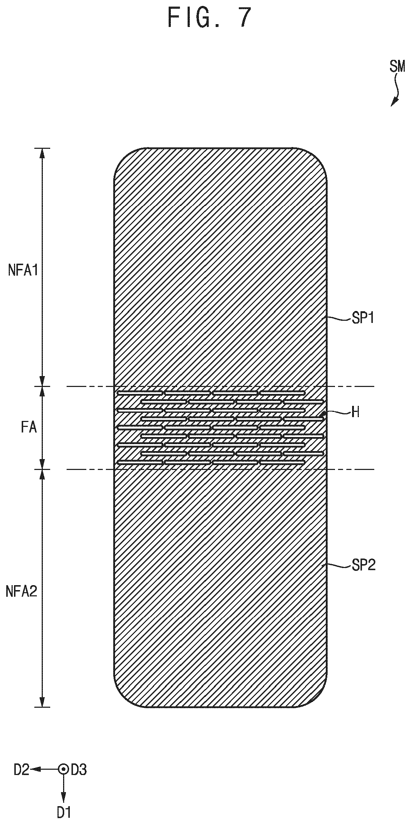

FIG. 5 is a schematic cross-sectional view illustrating a display module included in the display device of FIG. 3. FIG. 6 is a schematic cross-sectional view illustrating a display panel included in the display module of FIG. 5. FIG. 7 is a schematic plan view illustrating a support member included in the display module of FIG. 5.

Referring to FIG. 5, the display module DM may include a support member SM, a first adhesive layer ADL1, a protective film PFM, a second adhesive layer ADL2, a display panel PNL, a third adhesive layer ADL3, a window WIN, and a protective layer PL.

Referring to FIGS. 5 and 7, the support member SM may support the display panel PNL. The support member SM may be formed of a material having high rigidity. For example, the support member SM may include invar, which is an alloy of nickel (Ni) and iron (Fe), stainless steel (SUS), titanium (Ti), copper (Cu), or the like.

A hole H overlapping the folding portion FA may be defined in the support member SM. The hole H may penetrate the support member SM in the third direction D3 (or thickness direction). Accordingly, the folding characteristics of the display device DD may be improved.

For example, as shown in FIG. 7, the holes H may extend in the second direction D2 and be arranged side by side in the first direction D1. For example, the holes H may have a long side in the second direction D2 and a short side in the first direction D1. However, the shape of the holes H is not limited thereto. For example, the shape of the holes H may be appropriately set in response to the folding characteristics of the display module DM.

Referring back to FIG. 5, the first adhesive layer ADL1 may be disposed on the support member SM. The first adhesive layer ADL1 may include an adhesive material such as a pressure-sensitive adhesive (PSA), an optically clear adhesive (OCA), or an optically clear adhesive resin (OCR). The first adhesive layer ADL1 may contact the support member SM and may adhere the support member SM to the protective film PFM.

The protective film PFM may be disposed on the first adhesive layer ADL1. The protective film PFM may be formed of plastic. The protective film PFM may support the display panel PNL and may absorb external impact.

The display device DD may further include a buffer member. For example, the buffer member may be disposed between the display panel PNL and the support member SM and may buffer an external impact. The buffer member may include a material that contains air and may buffer, such as a cushion or a sponge. The buffer member may include an acrylic resin, polyurethane, thermoplastic polyurethane, latex, polyurethane foam, polystyrene foam, or the like.

The second adhesive layer ADL2 may be disposed on the protective film PFM. The second adhesive layer ADL2 may include an adhesive material such as a pressure-sensitive adhesive (PSA), an optically clear adhesive (OCA), or an optically clear adhesive resin (OCR). The second adhesive layer (ADL2) may contact the protective film PFM and may adhere the protective film PFM to the display panel PNL.

Referring to FIGS. 5 and 6, the display panel PNL may be disposed on the second adhesive layer ADL2. The display panel PNL may include a substrate SUB, a buffer layer BFR, an active pattern ACT, a first insulating layer ILD1, a gate electrode GAT, a second insulating layer ILD2, a first connection electrode CE1, a second connection electrode CE2, a third insulating layer ILD3, a pixel electrode ADE, an emission layer EL, a common electrode CTE, a pixel defining layer PDL, a first inorganic layer IL1, an organic layer OL, and a second inorganic layer IL2.

The substrate SUB may include glass, quartz, plastic, etc. For example, the substrate SUB may be a plastic substrate and may include polyimide (PI). The substrate SUB may have a structure in which at least one polyimide layer and at least one barrier layer are alternately stacked.

The buffer layer BFR may be disposed on the substrate SUB. The buffer layer BFR may include silicon oxide, silicon nitride, or the like. The buffer layer BFR may prevent impurities from diffusing into the active pattern ACT.

The active pattern ACT may be disposed on the buffer layer BFR. For example, the active pattern ACT may include a silicon semiconductor, an oxide semiconductor, etc. The silicon semiconductor may include amorphous silicon, polycrystalline silicon, etc. The active pattern ACT may pass current or block current according to a gate signal provided to the gate electrode GAT.

The first insulating layer ILD1 disposed on the buffer layer BFR may include an insulating material and may cover the active pattern ACT. For example, the first insulating layer ILD1 may include silicon oxide, silicon nitride, titanium oxide, tantalum oxide, or the like. The first insulating layer ILD1 may electrically insulate the active pattern ACT and the gate electrode GAT.

The gate electrode GAT disposed on the first insulating layer ILD1 may include a metal, an alloy, a conductive metal oxide, or the like, and may be disposed on the first insulating layer ILD1. For example, the gate electrode GAT may include silver (Ag), an alloy containing silver, molybdenum (Mo), an alloy containing molybdenum, aluminum (Al), an alloy containing aluminum, aluminum nitride (AlN), tungsten (W), tungsten nitride (WN), copper (Cu), nickel (Ni), chromium (Cr), chromium nitride (CrN), titanium (Ti), tantalum (Ta), platinum (Pt), scandium (Sc), indium tin oxide (ITO), indium zinc oxide (IZO), or the like.

The second insulating layer ILD2 disposed on the first insulating layer ILD1 may include an insulating material and may cover the gate electrode GAT. For example, the second insulating layer ILD2 may include silicon oxide, silicon nitride, titanium oxide, tantalum oxide, or the like. The second insulating layer ILD2 may electrically insulate the gate electrode GAT from the first connection electrode CE1 and electrically insulate the gate electrode GAT from the second connection electrode CE2.

The first connection electrode CE1 and the second connection electrode CE2 may be disposed on the second insulating layer ILD2 and may be electrically connected to the active pattern ACT.

The first connection electrode CE1 and the second connection electrode CE2 may include a metal, an alloy, a conductive metal oxide, or the like. For example, the first and second connection electrodes CE1 and CE2 may include silver (Ag), an alloy containing silver, molybdenum (Mo), an alloy containing molybdenum, aluminum (Al), an alloy containing aluminum, aluminum nitride (AlN), tungsten (W), tungsten nitride (WN), copper (Cu), nickel (Ni), chromium (Cr), chromium nitride (CrN), titanium (Ti), tantalum (Ta), platinum (Pt), scandium (Sc), indium tin oxide (ITO), indium zinc oxide (IZO), or the like.

The third insulating layer ILD3 disposed on the second insulating layer ILD2 may cover the first and second connecting electrodes CE1 and CE2, may include an organic insulating material, and may have a substantially flat upper surface. For example, the third insulating layer ILD3 may include a photoresist, a polyacrylic resin, a polyimide resin, an acrylic resin, or the like.

The pixel electrode ADE may be disposed on the third insulating layer ILD3 and may be electrically connected to the second connection electrode CE2. The pixel electrode ADE may receive a first voltage from the second connection electrode CE2.

The pixel electrode ADE may include a metal, an alloy, a conductive metal oxide, or the like. For example, the pixel electrode ADE may include silver (Ag), an alloy containing silver, molybdenum (Mo), an alloy containing molybdenum, aluminum (Al), an alloy containing aluminum, aluminum nitride (AlN), tungsten (W), tungsten nitride (WN), copper (Cu), nickel (Ni), chromium (Cr), chromium nitride (CrN), titanium (Ti), tantalum (Ta), platinum (Pt), scandium (Sc), indium tin oxide (ITO), indium zinc oxide (IZO), or the like.

The pixel defining layer PDL may be disposed on the third insulating layer ILD3, and an opening exposing the upper surface of the pixel electrode ADE may be formed in the pixel defining layer PDL. For example, the pixel defining layer PDL may include an organic material such as a polyimide-based resin (e.g., a photosensitive polyimide-based resin (PSPI)), a photoresist, a polyacrylic-based resin, an acrylic resin, or an inorganic material such as silicon oxide and silicon nitride.

The emission layer EL may be disposed on the pixel electrode ADE. The emission layer EL may have a multilayer structure including an organic light-emitting layer, a hole injection layer, a hole transport layer, an electron transport layer, and an electron injection layer.

The common electrode CTE may be disposed on the emission layer EL and may provide a second voltage. The common electrode CTE may include a metal, an alloy, a conductive metal oxide, or the like. For example, the common electrode CTE may include silver (Ag), an alloy containing silver, molybdenum (Mo), an alloy containing molybdenum, aluminum (Al), an alloy containing aluminum, aluminum nitride (AlN), tungsten (W), tungsten nitride (WN), copper (Cu), nickel (Ni), chromium (Cr), chromium nitride (CrN), titanium (Ti), tantalum (Ta), platinum (Pt), scandium (Sc), indium tin oxide (ITO), indium zinc oxide (IZO), or the like.

By the voltage difference between the first voltage and the second voltage, the emission layer EL may generate light. Accordingly, the pixel electrode ADE, the emission layer EL, and the common electrode CTE may be defined as a light-emitting diode.

A thin film encapsulation layer may be disposed on the common electrode CTE. The thin film encapsulation layer may prevent moisture and oxygen from penetrating from the outside. For example, the thin film encapsulation layer may have a structure in which the first inorganic layer IL1, the organic layer OL, and the second inorganic layer IL2 are alternately stacked.

Referring back to FIG. 5, the third adhesive layer ADL3 may be disposed on the display panel PNL. The third adhesive layer ADL3 may include an adhesive material such as a pressure-sensitive adhesive (PSA), an optically clear adhesive (OCA), or an optically clear adhesive resin (OCR). The third adhesive layer ADL3 may contact the display panel PNL and may adhere the display panel PNL to the window WIN.

The window WIN may be disposed on the third adhesive layer ADL3 and the display panel PNL. The window WIN may protect the display panel PNL. For example, the window WIN may include colorless polyimide, ultra-thin tempered glass (UTG), polyethylene terephthalate (PET), polyimide (PI), polyethersulfone (PS), polyacrylate (PAR), polyetherimide (PEI), polyethylene naphthalate (PEN), polyphenylene sulfide (PPS), polycarbonate (PC), etc.

The protective layer PL may be disposed on the window WIN. The protective layer PL may protect the window WIN. The protective layer PL may include a plastic film and a hard coating layer. For example, the plastic film may include colorless polyimide, polyethylene terephthalate (PET), polyimide (PI), polyethersulfone (PS), polyacrylate (PAR), polyetherimide (PEI), polyethylene naphthalate (PEN), polyphenylene sulfide (PPS), polycarbonate (PC), or the like. The surface of the protective layer PL may be anti-fingerprint treated.

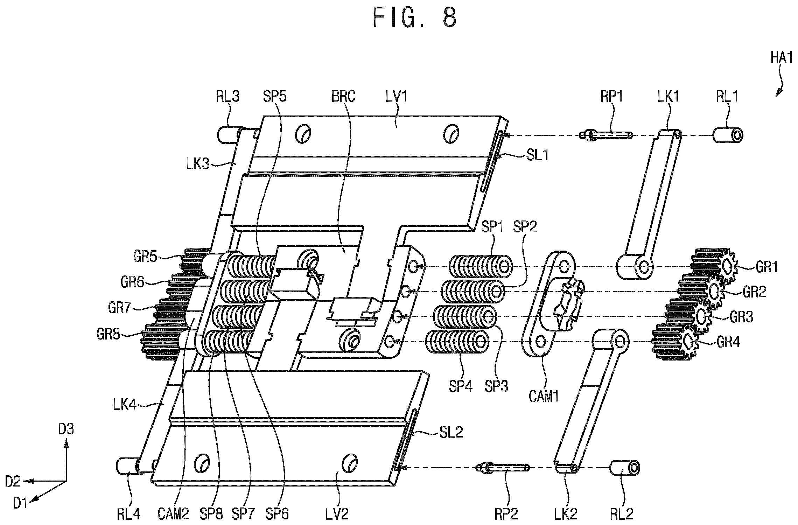

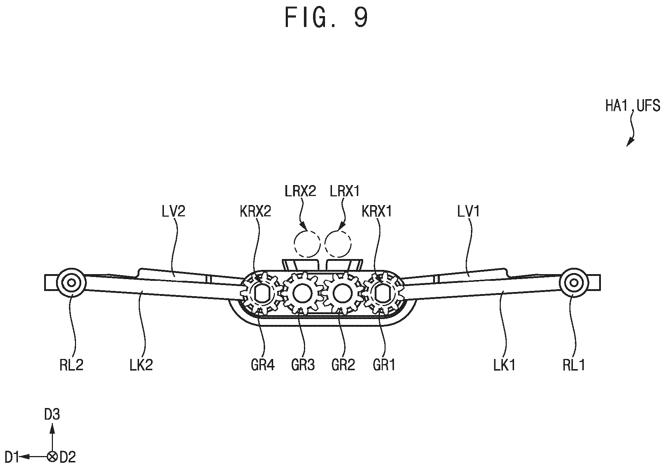

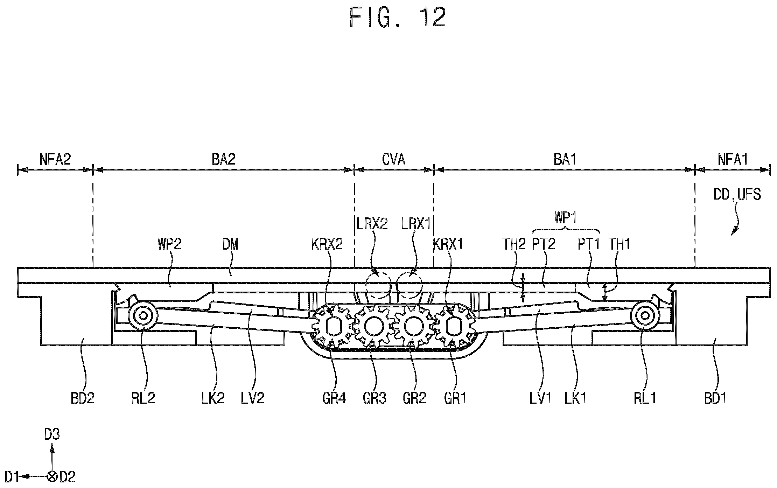

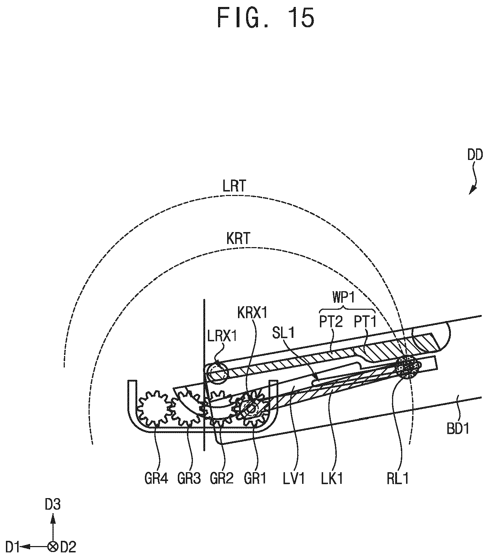

FIG. 8 is an exploded schematic perspective view illustrating a hinge assembly included in the display device of FIG. 3. FIGS. 9, 10, and 11 are schematic views illustrating the hinge assembly of FIG. 8. FIGS. 12, 13, and 14 are schematic views illustrating the display device of FIG. 3. FIG. 15 is a schematic view illustrating the display device of FIG. 3.

Referring to FIG. 8, the first hinge assembly HA1 may include a first lever LV1, a bracket BRC, a first link LK1, a first connecting portion CAM1, a first spring SP1, a second spring SP2, a third spring SP3, a fourth spring SP4, a first gear GR1, a second gear GR2, a third gear GR3, a fourth gear GR4, a first roller RL1, a first roller pin RP1, a second lever LV2, a second link LK2, a second roller RL2, a second roller pin RP2, a third link LK3, a second connecting portion CAM2, a fifth spring SP5, a sixth spring SP6, a seventh spring SP7, an eighth spring SP8, a fifth gear GR5, a sixth gear GR6, a seventh gear GR7, an eighth gear GR8, a third roller RL3, a fourth link LK4, and a fourth roller RL1.

The second hinge assembly HA2 may have substantially the same structure as the first hinge assembly HA1.

The first lever LV1 may have a body and a protrusion. For example, a first slot SL1 may be formed in the body of the first lever LV1, and the protrusion may be connected to the bracket BRC.

The bracket BRC may connect the first lever LV1 to the first link LK1. For example, the bracket BRC may be connected to the first link LK1 through the first to fourth springs SP1, SP2, SP3, and SP4, the first connecting portion CAM1, and the first to fourth gears GR1, GR2, GR3, and GR4.

The first link LK1 may be connected to the first lever LV1 through the first connecting portion CAM1, the first to fourth springs SP1, SP2, SP3, and SP4, and the bracket BRC.

For example, a groove corresponding to the first roller RL1 may be formed at an end of the first link LK1, and a groove corresponding to the first gear GR1 may be formed at another end of the first link LK1. The first link LK1 may rotate together with the first lever LV1 through the first to fourth gears GR1, GR2, GR3, and GR4.

The first connecting portion CAM1 may be disposed between the first lever LV1 and the first link LK1 and may connect the first lever LV1 and the first link LK1.

The first to fourth springs SP1, SP2, SP3, and SP4 may be disposed between the bracket BRC and the first connecting portion CAM1 and may connect the bracket BRC to the first connecting portion CAM1.

The first to fourth gears GR1, GR2, GR3, and GR4 may be connected to the first link LK1. For example, the first to fourth gears GR1, GR2, GR3, and GR4 may be arranged in parallel along the first direction D1. The first gear GR1 may be connected between the first link LK1 and the second gear GR2, and the second gear GR2 may be connected between the first gear GR1 and the first lever LV1.

The first roller RL1 may be fixed (or fixedly attached) to the first link LK1. For example, a groove may be formed at an end of the first link LK1, and the first roller RL1 may be fixed (or fixedly attached) to the first link LK1 by the groove and the first roller pin RP1.

The first roller pin RP1 may be fixed (or fixedly attached) to the first link LK1 and may be coupled with the first slot SL1. The first roller pin RP1 may move along the first slot SL1. Accordingly, the first roller RL1 coupled to the first roller pin RP1 may move along the first slot SL1.

The second lever LV2 may correspond to the first lever LV1 with respect to the bracket BRC disposed therebetween and may have a body and a protrusion. For example, a second slot SL2 may be formed in the body of the second lever LV2, and the protrusion may be connected to the bracket BRC.

The bracket BRC may further connect the second lever LV2 to the second link LK2. For example, the bracket BRC may be further connected to the second link LK2 through the first to fourth springs SP1, SP2, SP3, and SP4, the first connecting portion CAM1, and the first to fourth gears GR1, GR2, GR3, and GR4.

The second link LK2 may be connected to the first lever LV1 through the first connecting portion CAM1, the first to fourth springs SP1, SP2, SP3, and SP4, and the bracket BRC.

For example, a groove corresponding to the second roller RL2 may be formed at an end of the second link LK2, and a groove corresponding to the fourth gear GR4 may be formed at another end of the second link LK2. The second link LK2 may rotate together with the second lever LV2 through the first to fourth gears GR1, GR2, GR3, and GR4.

The first connecting portion CAM1 may be disposed between the second lever LV2 and the second link LK2, and may further connect the second lever LV2 to the second link LK2.

The first to fourth gears GR1, GR2, GR3, and GR4 may be further connected to the second link LK2. For example, the first to fourth gears GR1, GR2, GR3, and GR4 may be arranged in parallel along the first direction D1. The fourth gear GR4 may be connected between the second link LK2 and the third gear GR3, and the third gear GR3 may be connected between the fourth gear GR4 and the second lever LV2.

The second roller RL2 may be fixed (or fixedly attached) to the second link LK2. For example, a groove may be formed at an end of the second link LK2, and the second roller RL1 may be fixed (or fixedly attached) to the second link LK2 by the groove and the second roller pin RP2.

The second roller pin RP2 may be fixed (or fixedly attached) to the second link LK2 and may be coupled with the second slot SL2. The second roller pin RP2 may move along the second slot SL2. Accordingly, the second roller RL2 coupled to the second roller pin RP2 may move along the second slot SL2.

The third lever LV3 may have a body and a protrusion. For example, a third slot may be formed in the body of the third lever LV3, and the protrusion may be electrically connected to the bracket BRC.

The bracket BRC may further connect the first lever LV1 and the third link LK3. For example, the bracket BRC may be further connected to the third link LK3 through the fifth to eighth springs SP5, SP6, SP7, and SP8, the second connecting portion CAM2, and the fifth to eighth gears GR5, GR6, GR7, and GR8.

The third link LK3 may be connected to the first lever LV1 through the second connecting portion CAM2, the fifth to eighth springs SP5, SP6, SP7, and SP8, and the bracket BRC.

For example, a groove corresponding to the third roller RL3 may be formed at an end of the third link LK3, and a groove corresponding to the fifth gear GR5 may be formed at another end of the third link LK3. The third link LK3 may rotate together with the first lever LV1 through the fifth to eighth gears GR5, GR6, GR7, and GR8.

The second connecting portion CAM2 may be disposed between the first lever LV1 and the third link LK3 and may connect the first lever LV1 to the third link LK3.

The fifth to eighth springs SP5, SP6, SP7, and SP8 may be disposed between the bracket BRC and the second connecting portion CAM2 and may connect the bracket BRC to the second connecting portion CAM2.

The fifth to eighth gears GR5, GR6, GR7, and GR8 may be connected to the third link LK3. For example, the fifth to eighth gears GR5, GR6, GR7, and GR8 may be arranged in parallel along the first direction D1. The fifth gear GR5 may be connected between the third link LK3 and the sixth gear GR6, and the sixth gear GR6 may be connected between the fifth gear GR5 and the first lever LV1.

The third roller RL3 may be fixed (or fixedly attached) to the third link LK3. For example, a groove may be formed at an end of the third link LK3, and the third roller RL3 may be fixed (or fixedly attached) to the third link LK3 by the groove and the third roller pin.

The third roller pin may be fixed (or fixedly attached) to the third link LK3 and may be coupled with the third slot. The third roller pin may move along the third slot. Accordingly, the third roller RL3 coupled to the third roller pin may move along the third slot.

The second lever LV2 may have a body and a protrusion. For example, a fourth slot may be formed in the body of the second lever LV2, and the protrusion may be connected to the bracket BRC.

The bracket BRC may further connect the second lever LV2 and the fourth link LK4. For example, the bracket BRC may be further connected to the fourth link LK4 through the fifth to eighth springs SP5, SP6, SP7, and SP8, the second connecting portion CAM2, and the fifth to eighth gears GR5, GR6, GR7, and GR8.

The fourth link LK4 may be connected to the second lever LV2 through the second connecting portion CAM2, the fifth to eighth springs SP5, SP6, SP7, and SP8, and the bracket BRC.

For example, a groove corresponding to the fourth roller RL4 may be formed at an end of the fourth link LK4, and a groove corresponding to the eighth gear GR8 may be formed at another end of the fourth link LK4. The fourth link LK4 may rotate together with the second lever LV2 through the fifth to eighth gears GR5, GR6, GR7, and GR8.

The second connecting portion CAM2 may be disposed between the second lever LV2 and the fourth link LK4, and may further connect the second lever LV2 to the fourth link LK4.

The fifth to eighth gears GR5, GR6, GR7, and GR8 may be further connected to the fourth link LK4. For example, the fifth to eighth gears GR5, GR6, GR7, and GR8 may be arranged in parallel along the first direction D1. The eighth gear GR8 may be connected between the fourth link LK4 and the seventh gear GR7, and the seventh gear GR7 may be connected between the eighth gear GR8 and the second lever LV2.

The fourth roller RL4 may be fixed (or fixedly attached) to the fourth link LK4. For example, a groove may be formed at one end of the fourth link LK4, and the fourth roller RL4 may be fixed (or fixedly attached) to the fourth link LK4 by the groove and the fourth roller pin.

The fourth roller pin may be fixed (or fixedly attached) to the fourth link LK4 and may be coupled with the fourth slot. The fourth roller pin may move along the fourth slot. Accordingly, the fourth roller RL4 coupled to the fourth roller pin may move along the fourth slot.

The second link LK2 may be disposed adjacent to the first link LK1 in the first direction D1. The first lever LV1 may be disposed adjacent to the first link LK1 in the second direction D2, and the third link LK3 may be disposed adjacent to the first lever LV1 in the second direction D2. The first lever LV1 may be coupled between the first and third links LK1 and LK3.

The fourth link LK4 may be disposed adjacent to the third link LK3 in the first direction D1. The second lever LV2 may be disposed adjacent to the second link LK2 in the second direction D2, and the fourth link LK4 may be disposed adjacent to the second lever LV2 in the second direction D2. The second lever LV2 may be coupled between the second and fourth links LK2 and LK4.

Referring to FIGS. 9, 10, and 11, the first hinge assembly HA1 may have an unfolded state UFS, a first folding state FP1, a second folding state FP2, and a folded state FS. For example, the first folding state FP1 may follow the unfolded state UFS, the second folding state FP2 may follow the first folding state FP1, and the folded state FS may follow the second folding state FP2.

As shown in FIG. 9, the first hinge assembly HA1 may have the unfolded state UFS. For example, between the first link LK1 and the second link LK2, the first hinge assembly HA1 may be unfolded by about 180°.

The first lever LV1 may rotate about a first lever rotation axis LRX1, and the second lever LV2 may rotate about a second lever rotation axis LRX2. For example, the first lever rotation axis LRX1 may be positioned above the protrusion of the first lever LV1 and may be positioned above the first to fourth gears GR1, GR2, GR3, and GR4. The second lever rotation axis LRX2 may be positioned above the protrusion of the second lever LV2 and may be positioned above the first to fourth gears GR1, GR2, GR3, and GR4.

The first link LK1 may rotate around a first link rotation axis KRX1, and the second link LK2 may rotate around a second link rotation axis KRX2. For example, in case that the first link LK1 is connected to the first gear GR1, the first link rotation axis KRX1 may coincide with the center of the first gear GR1. In case that the second link LK2 is connected to the fourth gear GR4, the second link rotation axis KRX2 may coincide with the center of the fourth gear GR2. Accordingly, the first link rotation axis KRX1 may be positioned under the first lever rotation axis LRX1, and the second link rotation axis KRX2 may be positioned under the second lever rotation axis LRX2.

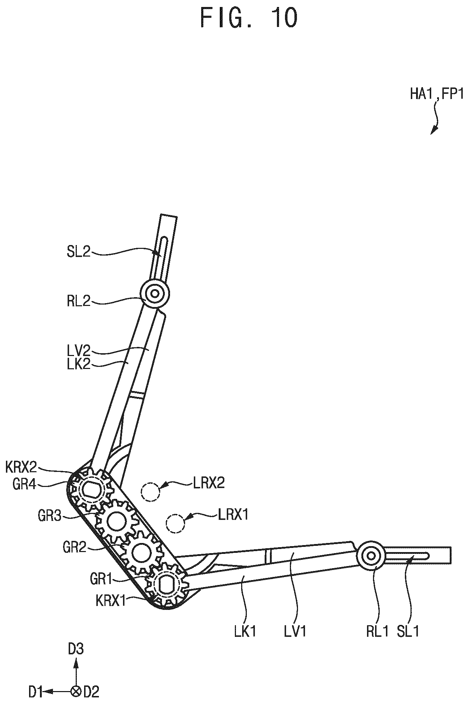

As shown in FIG. 10, the first hinge assembly HA1 may have the first folding state FP1. For example, between the first link LK1 and the second link LK2 or between the first lever LV1 and second lever LV2, the first hinge assembly HA1 may be unfolded in a range of about 70° to about 120°.

Since the position of the first lever rotation axis LRX1 and the position of the first link rotation axis KRX1 are different from each other, the first roller RL1 may move along the first slot SL1. In other embodiments, in case that the first lever LV1 rotates along the first lever rotation axis LRX1, the first link LK1 may rotate around the first link rotation axis KRX1 which is different from the first lever rotation axis LRX1. Accordingly, the first roller RL1 may perform a linear movement while being guided by the first slot SL1.

Since the position of the second lever rotation axis LRX2 and the position of the second link rotation axis KRX2 are different from each other, the second roller RL2 may move along the second slot SL2. In other embodiments, in case that the second lever LV2 rotates along the second lever rotation axis LRX2, the second link LK2 may rotate around the second link rotation axis KRX2 which is different from the second lever rotation axis LRX2. Accordingly, the second roller RL2 may perform a linear movement while being guided by the second slot SL2.

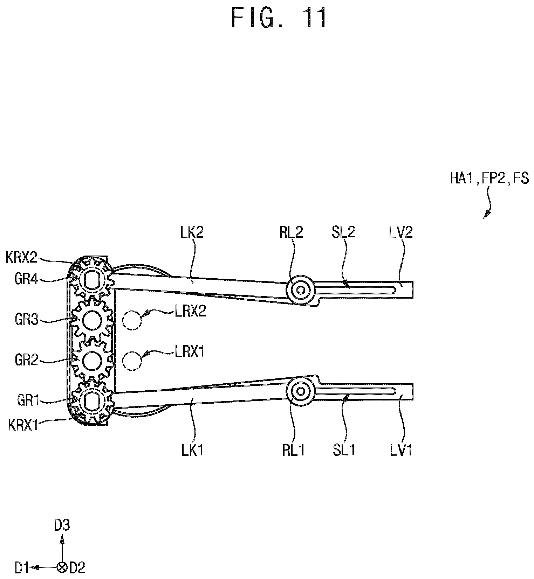

As shown in FIG. 11, the first hinge assembly HA1 may have the second folding state FP2 and the folding state FS. For example, between the first link LK1 and the second link LK2 or between the first lever LV1 and second lever LV2, the first hinge assembly HA1 may be folded in a range of about 70° to about 0°.

Since the position of the first lever rotation axis LRX1 and the position of the first link rotation axis KRX1 are different from each other, the first roller RL1 may move along the first slot SL1.

Since the position of the second lever rotation axis LRX2 and the position of the second link rotation axis KRX2 are different from each other, the second roller RL2 may move along the second slot SL2.

Referring to FIGS. 12, 13, and 14, the display device DD may have the unfolded state UFS, the first folding state FP1, the second folding state FP2, and the folded state FS, corresponding to the first hinge assembly HA1.

As shown in FIG. 12, the display device DD may have the unfolded state UFS. For example, between the first link LK1 and the second link LK2 or between the first lever LV1 and second lever LV2, the display device DD may be unfolded by about 180°. Thus, the surface of the display device DD may be substantially flat.

The folding portion FA may include a curved portion CVA, a first bend portion BA1, and a second bend portion BA2. The first bend portion BA1 may be positioned between the curved portion CVA and the first non-folded portion NFA1, the curved portion CVA may be positioned between the first and second bend portions BA1 and BA2, and the second bend portion BA2 may be positioned between the curved portion CVA and the second non-folded portion NFA2.

In case that the display device DD is in the unfolded state UFS, the curved portion CVA, the first bend portion BA1, and the second bend portion BA2 may be in the unfolded state.

The first wing plate WP1 may be divided into a first portion PT1 and a second portion PT2. The first portion PT1 may be disposed adjacent to the first non-folding portion NFA1 and may have a first thickness TH1. The second portion PT2 may be connected to the first portion PT1, may have a second thickness TH2, and may be disposed adjacent to the first lever rotation axis LRX1.

The first thickness TH1 may be greater than the second thickness TH2 in the third direction D3. Since the first portion PT1 has a relatively larger thickness than the second portion PT2, the first wing plate WP1 may contact the first roller RL1 in the first portion PT1. In other embodiments, in the unfolded state UFS, the first roller RL1 may support the first portion PT1.

The first portion PT1 may include a lower surface and an upper surface. The lower surface may contact the first roller RL1, and the upper surface may face the lower surface and be parallel to the lower surface in the first direction D1. Accordingly, the display module DM supported by the upper surface may not be bent over.

The second wing plate WP2 may have substantially the same shape as the first wing plate WP1. Accordingly, in the unfolded state UFS, the second roller RL2 may support the second wing plate WP2.

The display device DD may further include a first body BD1 and a second body BD2.

The first body BD1 may be disposed under the display module DM and may primarily overlap the first non-folding portion NFA1. The first body BD1 may be coupled with the first lever LV1 and/or the first wing plate WP1. For example, the first body BD1 may be a driver (e.g., a printed circuit board (PCB) or the like) that drives the display module DM and/or a rear cover that supports the display module DM.

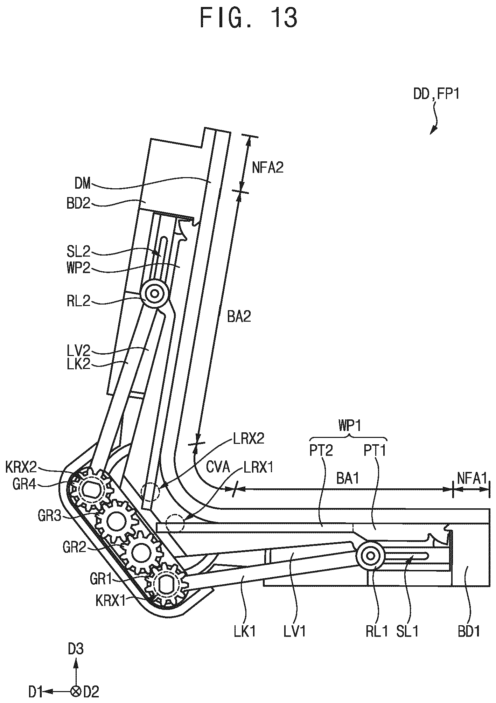

As shown in FIG. 13, the display device DD may have the first folding state FP1. For example, between the first link LK1 and the second link LK2 or between the first lever LV1 and second lever LV2, the display device DD may be unfolded in a range of about 70° to about 120°.

The curved portion CVA may be in-folded during the first folding state FP1.

The first roller RL1 may contact the first portion PT1 during the first folding state FP1. Accordingly, the first roller RL1 may support the first portion PT1 during the first folding state FP1. In case that the first portion PT1 is supported by the first roller RL1, the display module DM overlapping the first portion PT1 may not be folded. In other embodiments, during the first folding state FP1, the first bend portion BA1 may not be folded or bent over.

The second roller RL2 may contact the second wing plate WP2 during the first folding state FP1. Accordingly, the second bend portion BA2 may not be folded or bent over during the first folding state FP1.

During the first folding state FP1, the curved portion CVA may be in-folded. Accordingly, a user can unfold and use the display device DD at a desired angle. The first roller RL1 may support the first wing plate WP1 (for example, the first portion PT1), and the second roller RL2 may support the second wing plate WP2. Accordingly, the first bend portion BA1 and the second bend portion BA2 may not be folded or bent over. Accordingly, in case that the user uses the display device DD, wrinkles may not occur in the folding portion FA.

The length of the first portion PT1 may be appropriately set as needed. For example, the length of the first portion PT1 may correspond to the angle of the first folding state FP1.

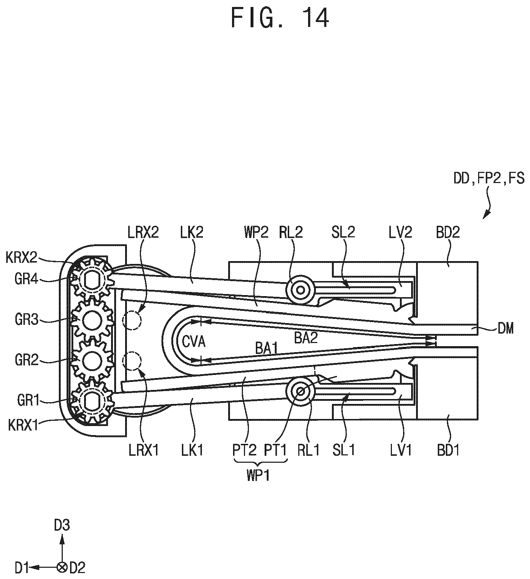

Referring to FIG. 14, the display device DD may have the second folding state FP2 and the folding state FS. For example, between the first link LK1 and the second link LK2 or between the first lever LV1 and second lever LV2, the display device DD may be folded in a range of about 70° to about 0°.

The curved portion CVA may be in-folded in the second folding state FP2 and the folding state FS.

The first roller RL1 may not contact the first portion PT1 during the second folding state FP2 and the folding state FS. Accordingly, the first roller RL1 may not support the first portion PT1 during the second folding state FP2 and the folding state FS.

For example, as described above, since the position of the first lever rotation axis LRX1 and the position of the first link rotation axis KRX1 are different from each other, the first wing plate WP1 may be folded by the reaction force of the display module DM. Therefore, in the second folding state FP2 and the folding state FS, the first bend portion BA1 may be out-folded. In other embodiments, in case that the first roller RL1 does not support the first portion PT1, the display module DM overlapping the boundary of the first portion PT1 may be folded. Through the same principle, the second bend portion BA2 may be out-folded. In other embodiments, in case that the second roller RL2 does not support the second wing plate WP2, the display module DM overlapping the boundary of the second wing plate WP2 may be folded.

Accordingly, in case that the user carries the display device DD, an increase in the thickness of the display device DD may be compensated (or reduced).

Referring to FIG. 15, as described above, the position of the first lever rotation axis LRX1 may be different from the position of the first link rotation axis KRX1. Accordingly, a first lever rotation trajectory LRT may be different from a first link rotation trajectory KRT. The first roller RL1 may be guided by the first slot SL1 and may move linearly. In other embodiments, the display device DD may induce the rotation trajectory of the lever and the rotation trajectory of the link differently by using two rotation axes LRX1 and KRX1 located at different positions. The linear movement of the roller may be induced by using the difference between the rotation trajectories described above.

The first wing plate WP1 may have the first portion PT1 with the first thickness TH1 (see FIG. 12) that is relatively thicker than the second thickness TH2 (see FIG. 12) of the second portion PT2, and accordingly, the first portion PT1 may be supported by the first roller RL1.

Accordingly, during the first folding state FP1, the curved portion CVA of the display device DD may be in-folded, and the first and second bend portions BA1 and BA2 may be neither bent nor folded. Accordingly, wrinkles may not occur in the folding portion FA in case that the user uses the display device DD.

In the second folding state FP2 and the folding state FS, the curved portion CVA may be in-folded, and the first and second bend portions BA1 and BA2 may be out-folded. Accordingly, in case that the user carries the display device DD, an increase in the thickness of the display device DD can be compensated (or reduced).

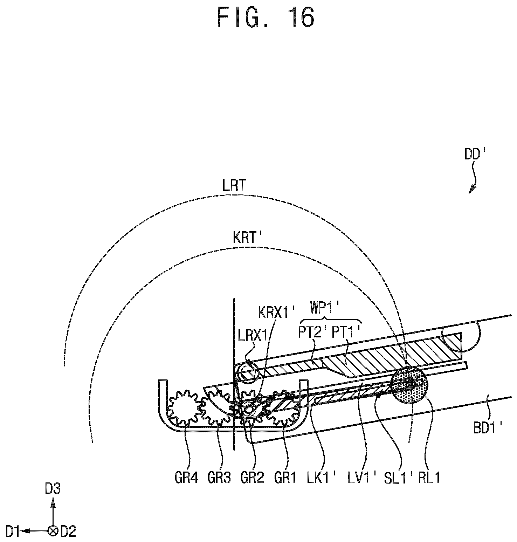

FIG. 16 is a schematic view illustrating a display device according to another embodiment of the disclosure.

Referring to FIG. 16, a display device DD' according to another embodiment of the disclosure may be substantially the same as the display device DD described above, except for the gear to which the link is connected, the position where the slot is formed, and the shape of the wing plate.

The display device DD' may include a first lever LV1' and a first link LK1', and the first link LK1' may be connected to a second gear GR2. In other embodiments, the second gear GR2 may be connected between the first lever LV1' and the first link LK1', and the first gear GR1 may be connected to the second gear GR2. Accordingly, a position of the first link rotation axis KRX1' may substantially coincide with the center of the second gear GR2. Therefore, a first link rotation trajectory KRT' may be different from the first lever rotation trajectory LRT.

The first slot SL1' may be formed in a configuration other than the first lever LV1'. For example, the first slot SL1' may be formed in a first body BD1'. The first roller RL1 may move linearly along the first slot SL1'.

The shape of the first wing plate WP1' including a first portion PT1' and a second portion PT2' may be appropriately set as needed. For example, the length of a first portion PT1' and the thickness of the first portion PT1' may correspond to the angles of the first and second folding states FP1 and FP2.

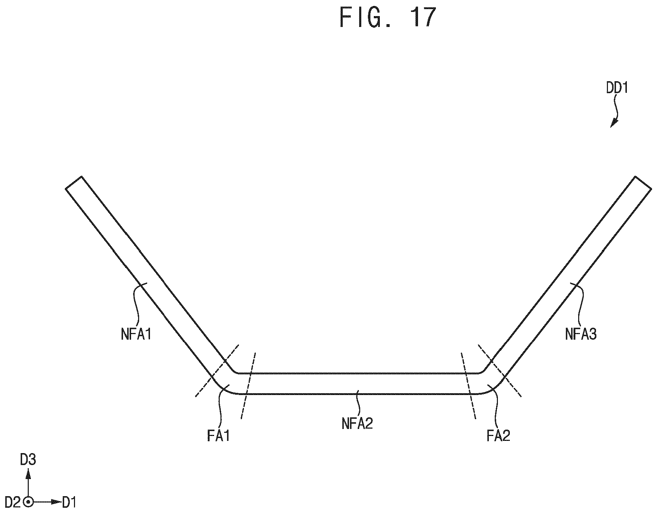

FIG. 17 is a schematic cross-sectional view illustrating a display device according to still another embodiment of the disclosure.

Referring to FIG. 17, a display device DD1 according to still another embodiment of the disclosure may include at least one folding portion and at least one non-folding portion. For example, as shown in FIG. 17, the display device DD1 may include a first non-folding portion NFA1, a first folding portion FA1, a second non-folding portion NFA2, a second folding portion FA2, and a third non-folding portion NFA3. The second non-folding portion NFA2 may be disposed adjacent to the first non-folding portion NFA1 in the first direction D1, and the first folding portion FA1 may be positioned between the first and second non-folding portions NFA1 and NFA2. The third non-folding portion NFA3 may be disposed adjacent to the second non-folding portion NFA2 in the first direction D1, and the second folding portion FA2 may be positioned between the second and third non-folding portions NFA2 and NFA3.

The first non-folding portion NFA1, the first folding portion FA1, the second non-folding portion NFA2, the second folding portion FA2, and the third non-folding portion NFA3 may display an image.

The first and second folding portions FA1 and FA2 may perform folding and unfolding repeatedly. For example, the first and second folding portions FA1 and FA2 may be in-folded.

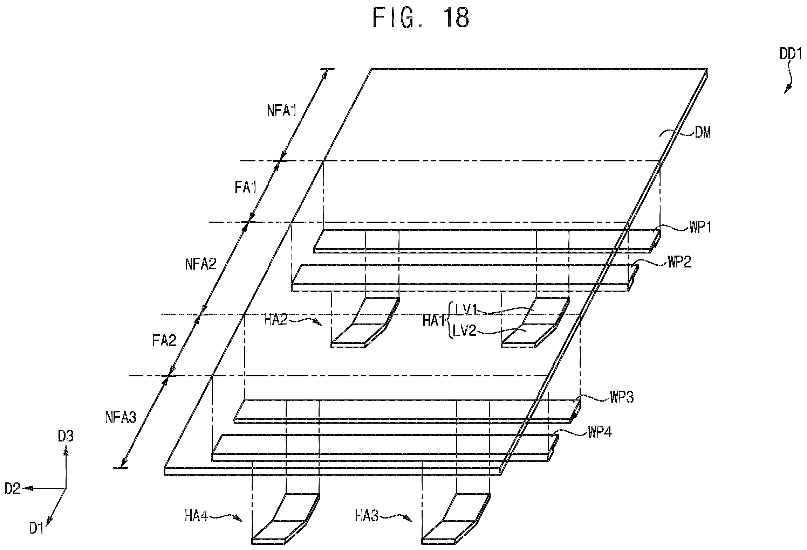

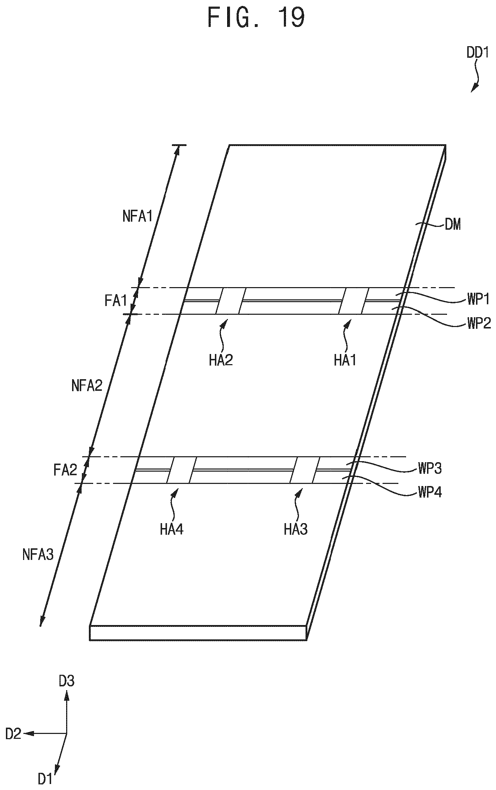

FIG. 18 is an exploded schematic perspective view illustrating the display device of FIG. 17. FIG. 19 is a schematic perspective view illustrating the display device of FIG. 17.

Referring to FIGS. 18 and 19, the display device DD1 may include a display module DM, a first wing plate WP1, a second wing plate WP2, a first hinge assembly HA1, a second hinge assembly HA2, a third wing plate WP3, a fourth wing plate WP4, a third hinge assembly HA3, and a fourth hinge assembly HA4.

The display module DM may include a display panel and display an image.

The first wing plate WP1 may be disposed under the display module DM and may overlap the first folding portion FA1 in the third direction D3. For example, the first wing plate WP1 may extend in the second direction D2 and may overlap the first folding portion FA1 disposed adjacent to the first and second non-folding portions NFA1 and NFA2.

The second wing plate WP2 may be disposed under the display module DM and may overlap the first folding portion FA1 in the third direction D3. For example, the second wing plate WP2 may extend in the second direction D2, may be disposed adjacent to the first wing plate WP1 in the first direction D1, and may overlap the first folding portion FA1 disposed adjacent to the first and second non-folding portions NFA1 and NFA2.

The first hinge assembly HA1 may be disposed under the first and second wing plates WP1 and WP2. For example, the first hinge assembly HA1 may include a first lever LV1 and a second lever LV2. The first lever LV1 may correspond to the first wing plate WP1, and the second lever LV2 may correspond to the second wing plate WP2.

The second hinge assembly HA2 may be disposed under the first and second wing plates WP1 and WP2. For example, the second hinge assembly HA2 may have the same shape as the first hinge assembly HA1 and may be disposed adjacent to the first hinge assembly HA1 in the second direction D2.

The first and second hinge assemblies HA1 and HA2 may serve as hinges that guide folding and unfolding. The first and second wing plates WP1 and WP2 can evenly transmit the force generated from the first and second hinge assemblies HA1 and HA2 to the first folding portion FA1.

The third wing plate WP3 may be disposed under the display module DM and may overlap the second folding portion FA2 in the third direction D3. For example, the third wing plate WP3 may extend in the second direction D2 and overlap the second folding portion FA2 disposed adjacent to the second and third non-folding portions NFA2 and NFA3.

The fourth wing plate WP4 may be under the display module DM and may overlap the second folding portion FA2 in the third direction D3. For example, the fourth wing plate WP4 may extend in the second direction D2, may be disposed adjacent to the third wing plate WP3 in the first direction D1, and may overlap the second folding portion FA2 disposed adjacent to the second and third non-folding portions NFA2 and NFA3.

The third hinge assembly HA3 may be disposed under the third and fourth wing plates WP3 and WP4. For example, the third hinge assembly HA3 may have the same shape as the first hinge assembly HA1 and may be disposed adjacent to the first hinge assembly HA1 in the first direction D1.

The fourth hinge assembly HA4 may be disposed under the third and fourth wing plates WP3 and WP4. For example, the fourth hinge assembly HA4 may have the same shape as the third hinge assembly HA3 and may be disposed adjacent to the third hinge assembly HA3 in the second direction D2.

The third and fourth hinge assemblies HA3 and HA4 may serve as hinges that guide folding and unfolding. The third and fourth wing plates WP3 and WP4 may evenly transmit the force generated from the third and fourth hinge assemblies HA3 and HA4 to the second folding portion FA2.

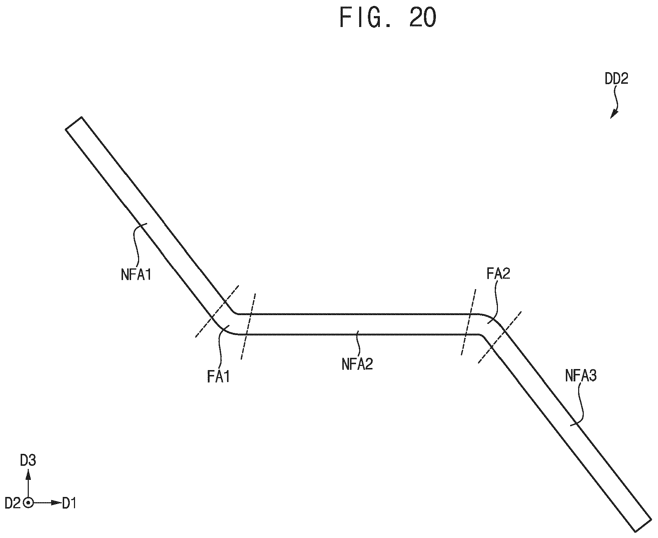

FIG. 20 is a schematic cross-sectional view illustrating a display device according to still another embodiment of the disclosure.

Referring to FIG. 20, a display device DD2 according to still another embodiment of the disclosure may include at least one folding portion and at least one non-folding portion. For example, as shown in FIG. 20, the display device DD2 may include a first non-folding portion NFA1, a first folding portion FA1, a second non-folding portion NFA2, a second folding portion FA2, and a third non-folding portion NFA3. The second non-folding portion NFA2 may be disposed adjacent to the first non-folding portion NFA1 in the first direction D1, and the first folding portion FA1 may be positioned between the first and second non-folding portions NFA1 and NFA2. The third non-folding portion NFA3 may be disposed adjacent to the second non-folding portion NFA2 in the first direction D1, and the second folding portion FA2 may be positioned between the second and third non-folding portions NFA2 and NFA3.

The first non-folding portion NFA1, the first folding portion FA1, the second non-folding portion NFA2, the second folding portion FA2, and the third non-folding portion NFA3 may display an image.

The first and second folding portions FA1 and FA2 may perform folding and unfolding repeatedly. For example, the first folding portion FA1 may be in-folded (i.e., folding inward), and the second folding portion FA2 may be out-folded (i.e., folding outward).

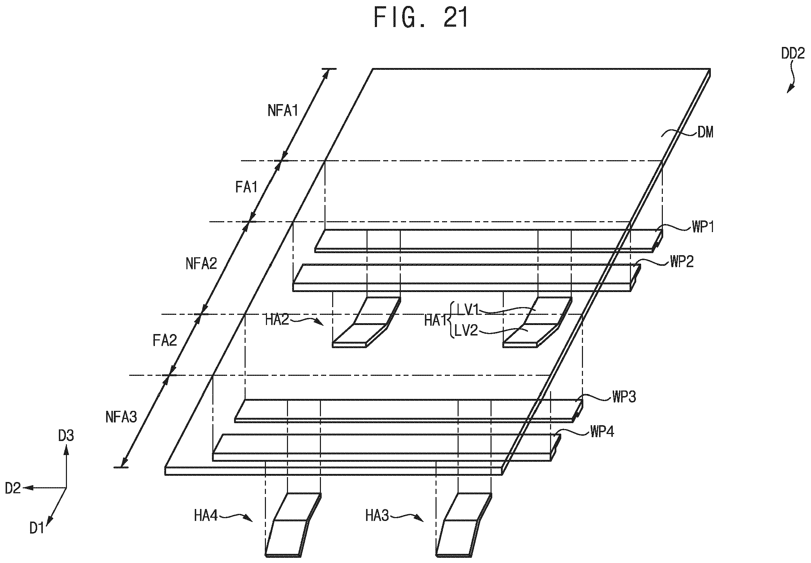

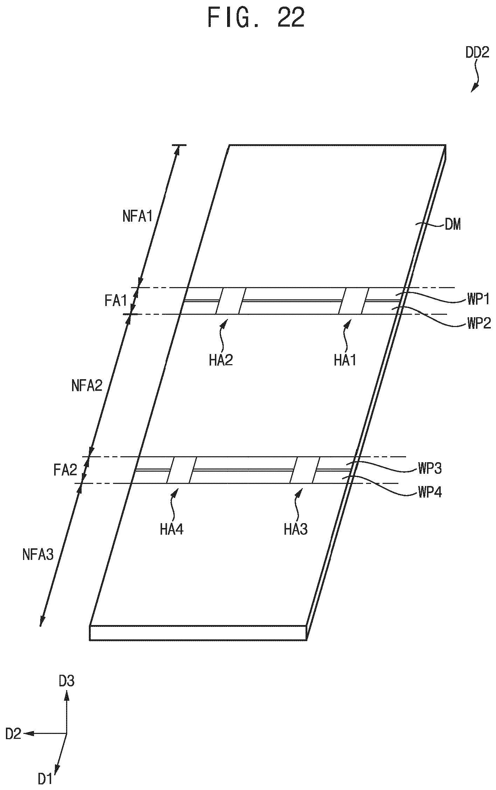

FIG. 21 is an exploded schematic perspective view illustrating the display device of FIG. 20. FIG. 22 is a schematic perspective view illustrating the display device of FIG. 20.

Referring to FIGS. 21 and 22, the display device DD2 may include a display module DM, a first wing plate WP1, a second wing plate WP2, a first hinge assembly HA1, a second hinge assembly HA2, a third wing plate WP3, a fourth wing plate WP4, a third hinge assembly HA3, and a fourth hinge assembly HA4.

The display module DM may include a display panel and display an image.

The first wing plate WP1 may be disposed under the display module DM and may overlap the first folding portion FA1 in the third direction D3. For example, the first wing plate WP1 may extend in the second direction D2 and may overlap the first folding portion FA1 disposed adjacent to the first and second non-folding portions NFA1 and NFA2.

The second wing plate WP2 may be disposed under the display module DM and may overlap the first folding portion FA1 in the third direction D3. For example, the second wing plate WP2 may extend in the second direction D2, may be disposed adjacent to the first wing plate WP1 in the first direction D1, and may overlap the first folding portion FA1 disposed adjacent to the first and second non-folding portions NFA1 and NFA2.

The first hinge assembly HA1 may be disposed under the first and second wing plates WP1 and WP2. For example, the first hinge assembly HA1 may include a first lever LV1 and a second lever LV2. The first lever LV1 may correspond to the first wing plate WP1, and the second lever LV2 may correspond to the second wing plate WP2.

The second hinge assembly HA2 may be disposed under the first and second wing plates WP1 and WP2. For example, the second hinge assembly HA2 may have the same shape as the first hinge assembly HA1 and may be disposed adjacent to the first hinge assembly HA1 in the second direction D2.

The first and second hinge assemblies HA1 and HA2 may serve as hinges that guide folding and unfolding. The first and second wing plates WP1 and WP2 may evenly transmit the force generated from the first and second hinge assemblies HA1 and HA2 to the first folding portion FA1.

The third wing plate WP3 may be disposed under the display module DM and may overlap the second folding portion FA2 in the third direction D3. For example, the third wing plate WP3 may extend in the second direction D2 and overlap the second folding portion FA2 disposed adjacent to the second and third non-folding portions NFA2 and NFA3.

The fourth wing plate WP4 may be disposed under the display module DM and may overlap the second folding portion FA2 in the third direction D3. For example, the fourth wing plate WP4 may extend in the second direction D2, may be disposed adjacent to the third wing plate WP3 in the first direction D1, and may overlap the second folding portion FA2 disposed adjacent to the second and third non-folding portions NFA2 and NFA3.

The third hinge assembly HA3 may be disposed under the third and fourth wing plates WP3 and WP4.

The fourth hinge assembly HA4 may be disposed under the third and fourth wing plates WP3 and WP4. For example, the fourth hinge assembly HA4 may have the same shape as the third hinge assembly HA3 and may be disposed adjacent to the third hinge assembly HA3 in the second direction D2.

The third and fourth hinge assemblies HA3 and HA4 may serve as hinges that guide folding and unfolding. The third and fourth wing plates WP3 and WP4 may evenly transmit the force generated from the third and fourth hinge assemblies HA3 and HA4 to the second folding portion FA2.

The display device DD, DD', DD1, and DD2 according to embodiments may be applied to various electronic devices. An electronic device according to an embodiment may include the display device DD, DD', DD1, and DD2 described above, and may further include a module or device having additional functions in addition to the display device DD, DD', DD1, and DD2.

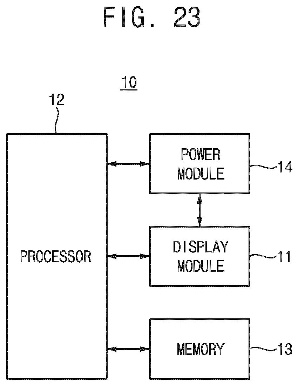

FIG. 23 is a schematic block diagram illustrating an electronic device according to an embodiment of the disclosure.

Referring to FIG. 23, an electronic device 10 may include a display module 11, a processor 12, a memory 13, and a power module 14.

The processor 12 may include at least one of a central processing unit (CPU), an application processor (AP), a graphic processing unit (GPU), a communication processor (CP), an image signal processor (ISP), and a controller.

The memory 13 may store data information necessary for an operation of the processor 12 or the display module 11. In case that the processor 12 executes an application stored in the memory 13, an image data signal and/or an input control signal may be transmitted to the display module 11, and the display module 11 may process the received signal and output image information through a display screen.

The power module 14 may include a power supply module such as a power adapter, a battery device, or the like and a power conversion module that converts power supplied by the power supply module to generate power necessary for an operation of the electronic device 10.

At least one of the components of the electronic device 10 described above may be included in the display device according to embodiments described above. Some of individual modules functionally included in one module may be included in the display device, and others may be provided separately from the display device. For example, the display device may include the display module 11, and the processor 12, the memory 13, and the power module 14 may be provided in form of other devices in the electronic device 10 other than the display device.

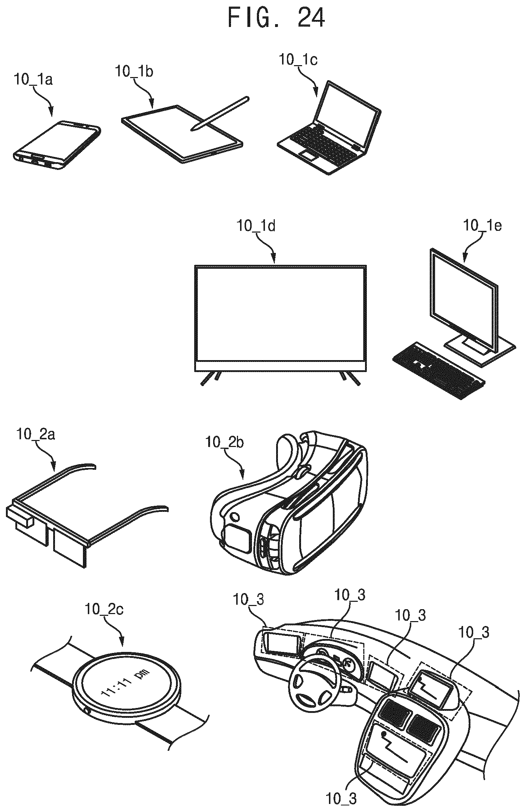

FIG. 24 is a schematic diagram of electronic devices.

Referring to FIG. 24, various electronic devices to which the display device according to embodiments are applied may include not only an image display electronic device, but also a wearable electronic device including a display module, a vehicle electronic device 10_3 including a display module, or the like. The image display electronic device may be a smartphone 10_1a, a tablet PC 10_1b, a laptop 10_1c, a TV 10_1d, a desk monitor 10_1e, or the like. The wearable electronic device may be smart glasses 10_2a, a head mounted display 10_2b, a smart watch 10_2c, or the like. The vehicle electronic device 10_3 may be a center information display (CID) disposed on a dashboard and center fascia of a vehicle, a room mirror display, or the like.

As discussed, embodiments can provide a display device comprising: a display module including a folding portion and at least one of a non-folding portion disposed adjacent to the folding portion; a first hinge assembly disposed under the display module and including a first lever, a first link, and a first roller; and a first wing plate disposed between the display module and the first hinge assembly, wherein the first lever overlaps the folding portion and is arranged to rotate around a first lever rotation axis, wherein the first link is arranged rotate around a first link rotation axis, and wherein the first roller is fixedly attached to the first link and is arranged to move along a first slot, and wherein the first wing plate overlaps the folding portion, is arranged to rotate along with the first lever, and is arranged to contact the first roller.

The first hinge assembly may serve as a hinge that guides folding and unfolding. The first wing plate may evenly transmit the force generated from the first hinge assembly to the folding portion.

The first roller may be guided by the first slot and may move linearly.

The first roller may support the first wing plate.

The first wing plate may include a first portion and a second portion having different thicknesses, and the relatively thick first portion may be supported by the first roller.

During the first folding state, a curved portion of the display device may be in-folded, and bend portions may not be bent or folded. Accordingly, no wrinkles can occur in the folding portion while the user uses the display device.

In addition, in the second folding state and in the folding state following the first folding state, the curved portion may be in-folded and the bend portions may be out-folded. Accordingly, an increase in the thickness of the display device may be compensated while the user carries the display device.

Embodiments can provide an electronic device comprising: a display device according to any of the above discussed embodiments, and a power supply arranged to supply power to the display device.

Although certain embodiments and implementations have been described herein, other embodiments and modifications will be apparent from this description. Accordingly, the disclosures are not limited to such embodiments, but rather to the broader scope of the appended claims and various obvious modifications and equivalent arrangements as would be apparent to a person of ordinary skill in the art.

## Claims

1. A display device (10, DD) comprising:
a display module (DM) including a folding portion (FA) and at least one of a non-folding portion (NFA1) disposed adjacent to the folding portion;
a first hinge assembly (HA1) disposed under the display module and including a first lever (LV1), a first link (LK1), and a first roller (RL1); and
a first wing plate (WP1) disposed between the display module and the first hinge assembly,
wherein the first lever overlaps the folding portion and is arranged to rotate around a first lever rotation axis (LRX1), wherein the first link is arranged to rotate around a first link rotation axis, and wherein the first roller is fixedly attached to the first link and is arranged to move along a first slot, and
**characterized in that**
the first wing plate overlaps the folding portion, is arranged to rotate along with the first lever, and is arranged to contact the first roller.

2. The display device of claim 1, wherein the folding portion includes a curved portion and a first bend portion disposed between the curved portion and the non-folding portion,
the curved portion is in-folded in a first folding state following an unfolding state, and
the first bend portion is out-folded in a second folding state following the first folding state.

3. The display device of claim 2, wherein the first wing plate is divided into a first portion and a second portion,
the first portion is disposed adjacent to the non-folding portion, and the second portion is connected to the first portion,
the second portion has a thickness smaller than a thickness of the first portion, and is disposed adjacent to the first lever rotation axis, and
the first roller contacts the first portion in the first folding state.

4. The display device of claim 3, wherein the first roller is arranged to support the first portion in the first folding state, and
wherein in case that the first portion is supported by the first roller, the display module overlapping the first portion is not folded.

5. The display device of claim 3 or 4, wherein the first roller does not support the first portion in the second folding state, and
wherein in case that the first portion is not supported by the first roller, the display module overlapping a boundary of the first portion is folded.

6. The display device of any one of claims 3 to 5, wherein the first portion includes:
a lower surface contacting the first roller; and
an upper surface facing the lower surface and parallel to the lower surface.

7. The display device of any one of claims 1 to 6, wherein a position of the first link rotation axis is different from a position of the first lever rotation axis, and
the first link rotation axis is positioned under the first lever rotation axis.

8. The display device of any one of claims 1 to 7, further comprising:
at least one gear connecting the first lever and the first link.

9. The display device of claim 8, wherein the gear includes a first gear and a second gear, wherein the first gear is connected between the second gear and the first link, and the second gear is connected between the first gear and the first lever; or
wherein the gear includes a first gear and a second gear, the first gear is connected to the second gear, and the second gear is connected between the first lever and the first link.

10. The display device of any one of claims 1 to 9, wherein a groove corresponding to the first roller is formed at an end of the first link, and
the first roller is fixedly attached to the first link in the groove through a first roller pin.

11. The display device of any one of claims 1 to 10, wherein the first slot is formed in the first lever.

12. The display device of any one of claims 1 to 11, wherein the first hinge assembly further includes:
a second lever arranged to rotate around a second lever rotation axis;
a second link arranged to rotate around a second link rotation axis; and
a second roller fixedly attached to the second link to move along a second slot;
optionally wherein the first hinge assembly further includes: a third link that rotates around the first link rotation axis and opposing the first link with the first lever; and a third roller fixedly attached to the third link and opposing the first roller with the first lever;
optionally further comprising: a second wing plate disposed between the display module and the first hinge assembly, wherein the second wing overlaps the folding portion, is arranged to rotate along with the second lever, and is arranged to contact the second roller.

13. The display device of any one of claims 1 to 12, further comprising:
a second hinge assembly disposed under the display module, overlapping the folding portion, and having a same shape as the first hinge assembly;
optionally wherein the display module includes a first folding portion and a second folding portion spaced apart from the first folding portion, and the first and second hinge assemblies overlaps the first folding portion;
optionally further comprising: a third hinge assembly disposed under the display module and overlapping the second folding portion.

14. The display device of any one of claims 1 to 13, wherein the display module includes:
a display panel; and
a support member disposed under the display panel and having a hole overlapping the folding portion.

15. An electronic device comprising:
a display device according to any one of claims 1 to 14;
a power supply arranged to supply power to the display device.

## Patentansprüche

1. Anzeigevorrichtung (10, DD), umfassend:
ein Anzeigemodul (DM), das einen Klappabschnitt (FA) und mindestens einen von einem Nichtklappabschnitt (NFA1), der benachbart zu dem Klappabschnitt platziert ist, enthält;
eine erste Scharnieranordnung (HA1), die unter dem Anzeigemodul platziert ist und einen ersten Hebel (LV1), ein erstes Verbindungsglied (LK1) und eine erste Rolle (RL1) enthält; und
eine erste Flügelplatte (WP1), die zwischen dem Anzeigemodul und der ersten Scharnieranordnung platziert ist,
wobei der erste Hebel den Klappabschnitt überlappt und so angeordnet ist, dass er sich um eine erste Hebeldrehachse (LRX1) dreht, wobei das erste Verbindungsglied so angeordnet ist, dass es sich um eine erste Verbindungsglieddrehachse dreht,
und wobei die erste Rolle fest an dem ersten Verbindungsglied befestigt ist und so angeordnet ist, dass sie sich entlang eines ersten Schlitzes bewegt, und
**dadurch gekennzeichnet, dass**
die erste Flügelplatte den Klappabschnitt überlappt, so angeordnet ist, dass sie sich zusammen mit dem ersten Hebel dreht, und so angeordnet ist, dass sie die erste Rolle berührt.

2. Anzeigevorrichtung nach Anspruch 1, wobei der Klappabschnitt einen gekrümmten Abschnitt und einen ersten Biegeabschnitt, der zwischen dem gekrümmten Abschnitt und dem Nichtklappabschnitt platziert ist, enthält,
der gekrümmte Abschnitt in einem ersten Klappzustand nach einem Aufklappzustand nach innen geklappt ist und
der erste Biegeabschnitt in einem zweiten Klappzustand nach dem ersten Klappzustand nach außen geklappt ist.

3. Anzeigevorrichtung nach Anspruch 2, wobei die erste Flügelplatte in einen ersten Abschnitt und einen zweiten Abschnitt unterteilt ist,
der erste Abschnitt benachbart zu dem Nichtklappabschnitt platziert ist und der zweite Abschnitt mit dem ersten Abschnitt verbunden ist,
der zweite Abschnitt eine Dicke aufweist, die kleiner als eine Dicke des ersten Abschnitts ist, und benachbart zu der ersten Hebeldrehachse platziert ist und
die erste Rolle den ersten Abschnitt in dem ersten Klappzustand berührt.

4. Anzeigevorrichtung nach Anspruch 3, wobei die erste Rolle so angeordnet ist, dass sie den ersten Abschnitt in dem ersten Klappzustand stützt, und
wobei in dem Fall, dass der erste Abschnitt durch die erste Rolle gestützt wird, das den ersten Abschnitt überlappende Anzeigemodul nicht geklappt ist.

5. Anzeigevorrichtung nach Anspruch 3 oder 4, wobei die erste Rolle den ersten Abschnitt in dem zweiten Klappzustand nicht stützt, und
wobei in dem Fall, dass der erste Abschnitt nicht durch die erste Rolle gestützt wird, das Anzeigemodul, das eine Begrenzung des ersten Abschnitts überlappt, geklappt ist.

6. Anzeigevorrichtung nach einem der Ansprüche 3 bis 5, wobei der erste Abschnitt Folgendes enthält:
eine untere Oberfläche, die die erste Rolle berührt; und
eine obere Oberfläche, die der unteren Oberfläche zugewandt und parallel zu der unteren Oberfläche ist.

7. Anzeigevorrichtung nach einem der Ansprüche 1 bis 6, wobei sich eine Position der ersten Verbindungsglieddrehachse von einer Position der ersten Hebeldrehachse unterscheidet und
die erste Verbindungsglieddrehachse unter der ersten Hebeldrehachse positioniert ist.

8. Anzeigevorrichtung nach einem der Ansprüche 1 bis 7, ferner umfassend:
mindestens ein Zahnrad, das den ersten Hebel und das erste Verbindungsglied verbindet.

9. Anzeigevorrichtung nach Anspruch 8, wobei das Zahnrad ein erstes Zahnrad und ein zweites Zahnrad enthält, wobei das erste Zahnrad zwischen dem zweiten Zahnrad und dem ersten Verbindungsglied verbunden ist und das zweite Zahnrad zwischen dem ersten Zahnrad und dem ersten Hebel verbunden ist; oder
wobei das Zahnrad ein erstes Zahnrad und ein zweites Zahnrad enthält, das erste Zahnrad mit dem zweiten Zahnrad verbunden ist und das zweite Zahnrad zwischen dem ersten Hebel und dem ersten Verbindungsglied verbunden ist.

10. Anzeigevorrichtung nach einem der Ansprüche 1 bis 9, wobei eine Nut, die der ersten Rolle entspricht, an einem Ende des ersten Verbindungsglieds ausgebildet ist und
die erste Rolle in der Nut durch einen ersten Rollenstift fest an dem ersten Verbindungsglied befestigt ist.

11. Anzeigevorrichtung nach einem der Ansprüche 1 bis 10, wobei der erste Schlitz in dem ersten Hebel ausgebildet ist.

12. Anzeigevorrichtung nach einem der Ansprüche 1 bis 11, wobei die erste Scharnieranordnung ferner Folgendes enthält:
einen zweiten Hebel, der so angeordnet ist, dass er sich um eine zweite Hebeldrehachse dreht;
ein zweites Verbindungsglied, das so angeordnet ist, dass es sich um eine zweite Verbindungsglieddrehachse dreht; und
eine zweite Rolle, die fest an dem zweiten Verbindungsglied befestigt ist, um sich entlang eines zweiten Schlitzes zu bewegen;
wobei optional die erste Scharnieranordnung ferner Folgendes enthält: ein drittes Verbindungsglied, das sich um die erste Verbindungsglieddrehachse dreht und dem ersten Verbindungsglied mit dem ersten Hebel gegenüberliegt; und eine dritte Rolle, die fest an dem dritten Verbindungsglied befestigt ist und der ersten Rolle mit dem ersten Hebel gegenüberliegt;
optional ferner umfassend: eine zweite Flügelplatte, die zwischen dem Anzeigemodul und der ersten Scharnieranordnung platziert ist, wobei der zweite Flügel den Klappabschnitt überlappt, so angeordnet ist, dass er sich zusammen mit dem zweiten Hebel dreht, und so angeordnet ist, dass er die zweite Rolle berührt.

13. Anzeigevorrichtung nach einem der Ansprüche 1 bis 12, ferner umfassend:
eine zweite Scharnieranordnung, die unter dem Anzeigemodul platziert ist, den Klappabschnitt überlappt und eine gleiche Form wie die erste Scharnieranordnung aufweist;
wobei optional das Anzeigemodul einen ersten Klappabschnitt und einen zweiten Klappabschnitt, der von dem ersten Klappabschnitt beabstandet ist, enthält und die erste und die zweite Scharnieranordnung den ersten Klappabschnitt überlappen;
optional ferner umfassend: eine dritte Scharnieranordnung, die unter dem Anzeigemodul platziert ist und den zweiten Klappabschnitt überlappt.

14. Anzeigevorrichtung nach einem der Ansprüche 1 bis 13, wobei das Anzeigemodul Folgendes enthält:
ein Anzeigefeld; und
ein Stützelement, das unter dem Anzeigefeld platziert ist und ein Loch aufweist, das den Klappabschnitt überlappt.

15. Elektronische Vorrichtung, umfassend:
eine Anzeigevorrichtung nach einem der Ansprüche 1 bis 14;
eine Leistungsversorgung, die so angeordnet ist, dass sie die Anzeigevorrichtung mit Leistung versorgt.

## Revendications

1. Dispositif d'affichage (10, DD), comprenant :
un module d'affichage (DM) comprenant une partie de pliage (FA) et au moins une partie de non pliage (NFA1) disposée adjacente à la partie de pliage ;
un premier ensemble charnière (HA1) disposé sous le module d'affichage et comprenant un premier levier (LV1), une première liaison (LK1) et un premier rouleau (RL1) ; et
une première plaque d'aile (WP1) disposée entre le module d'affichage et le premier ensemble charnière,
le premier levier chevauchant la partie de pliage et étant agencé pour tourner autour d'un premier axe de rotation de levier (LRX1), la première liaison étant agencée pour tourner autour d'un premier axe de rotation de liaison,
et le premier rouleau étant fixé à demeure à la première liaison et étant agencé pour se déplacer le long d'une première fente, et
**caractérisé en ce que**
la première plaque d'aile chevauche la partie de pliage, est agencée pour tourner avec le premier levier et est agencée pour entrer en contact avec le premier rouleau.

2. Dispositif d'affichage de la revendication 1, dans lequel la partie de pliage comprend une partie incurvée et une première partie courbée disposée entre la partie incurvée et la partie de non pliage,
la partie incurvée est pliée vers l'intérieur dans un premier état de pliage suivant un état de dépliage, et
la première partie courbée est pliée vers l'extérieur dans un second état de pliage suivant le premier état de pliage.

3. Dispositif d'affichage de la revendication 2, dans lequel la première plaque d'aile est divisée en une première partie et une seconde partie,
la première partie est disposée adjacente à la partie de non pliage, et la seconde partie est connectée à la première partie,
la seconde partie a une épaisseur inférieure à une épaisseur de la première partie et est disposée adjacente au premier axe de rotation du levier, et
le premier rouleau entre en contact avec la première partie dans le premier état de pliage.

4. Dispositif d'affichage de la revendication 3, dans lequel le premier rouleau est agencé pour supporter la première partie dans le premier état de pliage, et
dans lequel dans le cas où la première partie est supportée par le premier rouleau, le module d'affichage chevauchant la première partie n'est pas plié.

5. Dispositif d'affichage de la revendication 3 ou 4, dans lequel le premier rouleau ne supporte pas la première partie dans le second état de pliage, et
dans lequel dans le cas où la première partie n'est pas supportée par le premier rouleau, le module d'affichage chevauchant une limite de la première partie est plié.

6. Dispositif d'affichage de l'une quelconque des revendications 3 à 5, dans lequel la première partie comprend :
une surface inférieure en contact avec le premier rouleau ; et
une surface supérieure faisant face à la surface inférieure et parallèle à la surface inférieure.

7. Dispositif d'affichage de l'une quelconque des revendications 1 à 6, dans lequel une position du premier axe de rotation de liaison est différente d'une position du premier axe de rotation de levier, et
le premier axe de rotation de liaison est positionné sous le premier axe de rotation de levier.

8. Dispositif d'affichage de l'une quelconque des revendications 1 à 7, comprenant en outre :
au moins un engrenage reliant le premier levier et la première liaison.

9. Dispositif d'affichage de la revendication 8, dans lequel l'engrenage comprend un premier engrenage et un second engrenage, ledit premier engrenage étant relié entre le second engrenage et la première liaison, et ledit second engrenage étant relié entre le premier engrenage et le premier levier ; ou
dans lequel l'engrenage comprend un premier engrenage et un second engrenage, le premier engrenage est relié au second engrenage, et le second engrenage est relié entre le premier levier et la première liaison.

10. Dispositif d'affichage de l'une quelconque des revendications 1 à 9, dans lequel une rainure correspondant au premier rouleau est formée à une extrémité de la première liaison, et
le premier rouleau est fixé à demeure à la première liaison dans la rainure par l'intermédiaire d'un premier axe de rouleau.

11. Dispositif d'affichage de l'une quelconque des revendications 1 à 10, dans lequel la première fente est formée dans le premier levier.

12. Dispositif d'affichage de l'une quelconque des revendications 1 à 11, dans lequel le premier ensemble charnière comprend en outre :
un second levier agencé pour tourner autour d'un second axe de rotation de levier ;
une deuxième liaison agencée pour tourner autour d'un second axe de rotation de liaison ; et
un deuxième rouleau fixé à demeure à la deuxième liaison pour se déplacer le long d'une seconde fente ;
éventuellement dans lequel le premier ensemble charnière comprend en outre : une troisième liaison qui tourne autour du premier axe de rotation de liaison et s'oppose à la première liaison avec le premier levier ; et un troisième rouleau fixé à demeure à la troisième liaison et s'opposant au premier rouleau avec le premier levier ;
éventuellement comprenant en outre : une seconde plaque d'aile disposée entre le module d'affichage et le premier ensemble charnière, la seconde aile chevauchant la partie de pliage, étant agencée pour tourner avec le second levier et étant agencée pour entrer en contact avec le deuxième rouleau.

13. Dispositif d'affichage de l'une quelconque des revendications 1 à 12, comprenant en outre :
un deuxième ensemble charnière disposé sous le module d'affichage, chevauchant la partie de pliage et ayant la même forme que le premier ensemble charnière ;
éventuellement dans lequel le module d'affichage comprend une première partie de pliage et une seconde partie de pliage espacée de la première partie de pliage, et les premier et deuxième ensembles charnière chevauchent la première partie de pliage ;
éventuellement comprenant en outre : un troisième ensemble charnière disposé sous le module d'affichage et chevauchant la seconde partie de pliage.

14. Dispositif d'affichage de l'une quelconque des revendications 1 à 13, dans lequel le module d'affichage comprend :
un panneau d'affichage ; et
un élément de support disposé sous le panneau d'affichage et comportant un trou chevauchant la partie de pliage.

15. Dispositif électronique comprenant :
un dispositif d'affichage selon l'une quelconque des revendications 1 à 14 ;
une alimentation électrique agencée pour alimenter le dispositif d'affichage.
